# EUROPEAN PATENT APPLICATION

(11) **EP 1 930 470 A1**
(43) Date of publication of application: **11.06.2008**
(21) Application number: 06797084.8
(22) Date of filing: 30.08.2006
(51) Int. Cl.: C23C 16/27, B01D 39/20, C02F 1/46, C25B 11/03, C25B 11/06, C30B 29/04

(54) **DIAMOND COVERED SUBSTRATE, FILTRATION FILTER, AND ELECTRODE**

(30) Priority: 26.09.2005 JP 2005277030; 30.11.2005 JP 2005345029
(71) Applicant: Sumitomo Electric Industries, Ltd., Osaka-shi, Osaka 541-0041 (JP)
(72) Inventor: IZUMI, Kenji, Itami-shi Hyogo 664-0016 (JP); SEKI, Yuichiro, Itami-shi Hyogo 664-0016 (JP); IMAI, Takahiro, Itami-shi Hyogo 664-0016 (JP)
(74) Representative: Cross, Rupert Edward Blount
(86) International application number: PCT/JP2006/317111
(87) International publication number: WO 2007/034665

(57) **Abstract**

By providing a substrate that can be used as an electrode, the invention solves the problem of corrosion of the substrate itself during an electrochemical oxidation treatment, the problem of discontinued electrolysis caused by delamination between a diamond layer and a substrate, or the problem of severely impaired electrolysis efficiency. The present invention is a diamond-covered substrate comprising a substrate and a conductive diamond layer covering the substrate, wherein the largest area of the portion where the diamond comprising the diamond layer is continuous ranges from 1 µm² to 1, 000 µm². Preferably, the substrate is porous and has open pores, and the open pores preferably have a diameter from 0.1 µm to 1,000 µm.

## Description

### TECHNICAL FIELD

The present invention relates to a composite substrate in which a porous substrate is covered with a diamond layer, and to a filter and an electrode using the composite substrate.

### BACKGROUND ART

Diamond has characteristic properties then numerous products in many applications put into practical use by exploiting them. Diamond is physically and chemically stable, and is ordinarily an insulating material. Diamond can be electroconductive, however, by addition of impurities such as boron, nitrogen and the like.
Technologies for material disposal, effluent handling and recycling in industry have been all developed rapidly in recent years. One such technology is effluent filtration using ceramic filters. However, conventional ceramic filters are prone to corrosion when used in extremely corroding solutions and/or environments.
Electrochemical oxidation treatment technologies have also been known in order to reduce unwanted organic compounds in wastewater. The electrodes used in such electrochemical oxidation treatment include, for instance, platinum, lead dioxide and tin dioxide. These electrodes may also corrode during electrolysis processes when placed in chemically severe environments. Such electrodes are also problematic when used as anode, in that adsorbates form on the electrode working surface, which causes a serious efficiency loss.

Diamond is the most chemically stable substance, has excellent durability against oxidation, and prevents contamination of the substrate surface. Diamond exhibits superior aspects as an electrode because diamond is more corrosion-resistant than the above-described conventional filters and diamond imparted with conductivity can also maintain high-energy efficiency comparing to the above-described electrodes. Therefore, a substrate obtained by covering a porous substrate with diamond can be used as a highly durable filter. When used as an electrode, foreign matters adhered to the filter surface can be removed, while clogging of the filter can be prevented by reducing the passing foreign matters by an electrochemical oxidation treatment.

Patent Document 1 and Patent Document 2 disclose decomposing organic compounds in effluents by use of a diamond electrode. However, the examples described in these specifications do not illustrate an example of electrolysis at high current densities and over long time.
If a diamond electrode is used in organic solvent under a high current density condition, the diamond may delaminate at the interface between the film and the substrate through the electrolyte or generated gases. This delamination causes the underlying substrate to be exposed, thereby corrosion proceeds by the solution. Alternatively, severely impaired electrolysis efficiency poses another problem.

Patent Document 1: Japanese Patent Publication No. 2000-254650
Patent Document 2: Japanese Patent Publication No. 2000-226682

### DISCLOSURE OF THE INVENTION

An object of the present invention is to provide a substrate capable of being used as an electrode, in order to solve the above-described problem of corrosion of the substrate itself during electrochemical oxidation treatment, the problem of discontinued electrolysis treatment on account of delamination of the diamond layer from the substrate, or the problem of severely impaired electrolysis efficiency.
A further object of the invention is to provide a physically and chemically remarkably stable porous composite substrate having excellent durability and capable of being used in severe environments, by providing an electroconductive diamond covering layer on a porous substrate having open pores and having a filtration function.

By reducing the stresses within the electroconductive diamond layer, the electroconductive diamond-covered substrate of the present invention, used as an electrode, can prevent the problem of occurring delamination between the substrate and the electroconductive diamond layer during processes of electrochemical oxidation treatment.
The present invention adopts the constitutions below.
(1) A diamond-covered substrate comprising a substrate and a diamond layer covering the substrate, wherein a largest area of a continuous portion of the diamond comprising the diamond layer ranges between not less than 1 µm² and not more than 1, 000 µm².
(2) A diamond-covered substrate according to (1), wherein the diamond layer is electroconductive.
(3) A diamond-covered substrate according to (1) or (2), wherein the substrate is porous and has open pores.
(4) A diamond-covered substrate according to (3), wherein the open pore diameter of the porous substrate is 0.1 µm to 1,000 µm.

(5) A diamond-covered substrate according to any one of (1) to (4), wherein a material of the porous substrate is Al, Ta, Nb, Hf, Zr or Zn.
(6) A diamond-covered substrate according to any one of (1) to (5), wherein the diamond layer includes, as an impurity, at least one among boron, phosphorus and nitrogen.
(7) A diamond-covered substrate according to (6), wherein the electroconductive diamond layer includes 1 ppm to 100,000 ppm of boron.
(8) A diamond-covered substrate according to (7), wherein the electroconductive diamond layer includes 1 ppm to 50,000 ppm of boron.

(9) A filter, used a diamond-covered substrate according to any one of (1) to (8).
When the diamond-covered substrate according to the present invention is used as a filter, a excellently durable filter is provided by use of the diamond-covered substrate in which a substrate surface is covered by an electroconductive diamond layer, especially as regarding the problem of deteriorated filter durability such as decreasing strength of the whole substrate and lowering the filtration function, by the deterioration of the substrate surface caused by physical or chemical interactions between the solution to be filtered and the filter surface.

(10) An electrode using a diamond-covered substrate according to any one of (1) to (8) and/or a filter according to (9) as a cathode and/or an anode.
When the diamond-covered substrate or the filter according to the present invention is used as an electrode, reducing stresses in the electroconductive diamond layer can prevent the problem of occurring delamination between the electroconductive diamond layer and the substrate during electrochemical oxidation processes.

The present invention is explained in detail next.
The diamond-covered substrate according to the present invention can be used as a filter having a filtration function, and can be widely used as an electrode at the same time. It can be also used in high-speed zinc plating, manufacturing of electrolytic copper foil, and manufacturing of acidic water for cleaning or alkaline water.

For the diamond-covered substrate according to the present invention, electroconductivity is imparted by addition of impurities. The diamond-covered substrate which is covered with a diamond layer that has been made electroconductive can be used as an electrode. During an electrochemical oxidation treatment in a solution containing organic compounds, delamination may occur at the interface between the electroconductive diamond layer and substrate covered with the electroconductive diamond. It is understood that a load is exerted on the electroconductive diamond layer by hydrogen, oxygen and chlorine gas generated as a result of the electrochemical oxidation treatment. This load severely affects internal stresses inside the electroconductive diamond layer. Reducing such stress allows preventing delamination. When the area of continuous portion in the electroconductive diamond layer (hereinafter referred to as continuous film) is large, stress becomes larger, and hence a cause of delamination. The continuous film denotes herein portions where the electroconductive diamond layer itself electrically connects. In the present invention, reducing the nucleation density prevents formation of the continuous film of the diamond that constitutes the diamond layer, then, reducing stress in the film, thereby delamination is prevented. The nucleation density is preferably no larger than 1.0 × 10⁹ nuclei/cm² upon arbitrarily selected 1 mm square area. By restricting the portion of the continuous film of diamond constituting the diamond layer thus manufactured to 1,000 µm² or less, stress can be decreased and delamination between the electroconductive diamond layer and the substrate can be prevented. However, when the largest area of the continuous diamond portion is less than 1 µm², the size of the crystal particles becomes smaller, or the film thinner. In the former case the crystallinity of the diamond is impaired, while in the latter case efficiency of electrolysis is damaged as a result of higher resistance of the film.

A substrate to be covered with diamond has a filtration function by using a porous substrate. In this case the porous substrate should have open pores. When used only as a filter, the covering diamond does not need to be electroconductive.
The open pores of the porous substrate on which the electroconductive diamond film is formed have a diameter ranging preferably from 0.1 µm to 1,000 µm. If the open pore diameter is less than 0.1 µm, the diamond cover closes the pores, the passage of liquids is hindered, and hence the substrate cannot be used as a filter. An open pore diameter exceeding 1,000 µm, on the other hand, reduces the rigidity of the substrate, which gives rise to the problem of breakage during film formation or during use of the filter.

When used as an electrode, the substrate should be electroconductive, and has preferably low resistance. A metal substrate is preferably used and more preferably a noble metal or a valve metal that forms passive state on the substrate surface during an electrochemical oxidation treatment is used, in particular A1, Ta, Nb, Hf, Zr or Zn is preferred. Among these, Nb, which is little incompatible with diamond, affords enhanced delamination prevention.
Conductivity is imparted and resistance is decreased dramatically, by doping one or more impurities selected among boron, nitrogen and phosphorus in the diamond layer. Impurities of elements other than these are undesirable, as the diamond quality deteriorates.

The content ratio of boron can be controlled within 1 to 100,000 ppm, which allows obtaining a desirable resistance value. A yet more preferable resistance value can be obtained, in particular, by controlling the boron content ratio to be within 1 to 50,000 ppm. When below 1 ppm, the resistance of the diamond layer is low, which deteriorates power efficiency during electrolysis treatment. When above 100,000 ppm, diamond quality is impaired, and delamination between the substrate and the diamond layer is prone to occur.

The present invention is a diamond-covered substrate which has a filtration function and is also capable of being used as an electrode. This exhibits an effect that delamination between the electroconductive diamond layer and the substrate is prevented even during an electrochemical oxidation treatment process by preventing corrosion of the substrate itself and reducing stresses in the diamond layer.

### BEST MODE FOR CARRYING OUT THE INVENTION

When forming a film of the conductive diamond layer on the substrate, seeding such as scratching with a diamond powder or ultrasonic treatment is performed as a pretreatment, thereafter the film is formed. Vapor-phase synthesis is preferred as the method for synthesizing the electroconductive diamond. Preferred such methods are hot-filament CVD and/or plasma CVD. Synthesis is carried out by introducing hydrogen gas and a gas including carbon, for instance methane. The ratio of hydrogen: methane ranges preferably from 0.2% to 5%. When below 0.2% the carbon source is too small and the film formation consumes longer time, while above 5%, the carbon source is excessive, which lowers the quality of diamond. Impurities added to impart conductivity include, for instance, boron, phosphorus or nitrogen.

Durability was tested with use of diamond-covered substrates manufactured as described above by solution filtering and electrochemical oxidation treatment. The electrochemical oxidation treatment is performed, for instance, by placing one or two diamond electrodes in a container filled with a 1 mol/L aqueous solution of sulfuric acid. And, in the case of one diamond electrode, a suitable material such as platinum or carbon is used as a counterelectrode. The electrodes were fixed apart with a distance between them of about 10 mm, and then electric current was supplied. The test was performed under a condition of a current flow of 0.1A to 1.0 A/cm².

### EXAMPLES

### (Example 1)

A film of electroconductive diamond layer was formed by use of the substrates listed in Table 1. The substrate used here had an open pore diameter of about 1 µm. As a pretreatment, it was subjected to a scratching treatment with diamond powder, or an ultrasound treatment in a solution containing diamond powder dispersed therein. The size of the diamond powder varied from 0.2 µm to 3.0 µm.

Synthesis by hot filament CVD was carried out under a gas pressure of 60 Torr, hydrogen flow of 3,000 sccm, and a methane flow of 0.5 to 5.0 sccm. The boron source was diborane gas. The diborane flow was supplied at a concentration of 0.2 to 1.0% with respect to methane. The temperature of the substrate was 700 to 1,000°C. In the case of microwave CVD, the microwave frequency was 2.4 GHz, and the microwave output was 5 kW. In all cases the boron was contained in the range of from 10 ppm to 10,000 ppm.

As displayed in Table 1, nucleation density was changed by modifying the methane flow or the diamond seeding method in the pretreatment. Nucleation density was measured after 30 min of film formation. Further film formation was resumed thereafter, and then the surface area covered with the diamond was measured. Electrochemical oxidation treatment was carried out using the diamond-covered substrates as electrodes. Herein, ○ indicates no delamination, while × indicates impossibility of continuing the electrochemical oxidation treatment on account of delamination and/or substrate breakage. In the electroconductive oxidation treatment, the diamond electrodes as both of anode and cathode were used in a container filled with a 1 mol/L aqueous solution of sulfuric acid. The electrodes were fixed apart with a distance between them of 10 mm, and then electric current was supplied. The conditions were: current flow at 1.0 A/cm² for 100 hours.

**Table 1**

| No. | Substrate material | Nucleation density (nuclei/cm²) | Largest area of diamond continuous portion (µm²) | Delamination |
|---|---|---|---|---|
| 1-1 | Nb | 6.2×10⁵ | 0.9 | - |
| 1-2 | Nb | 5.9×10⁷ | 1.1 | ○ |
| 1-3 | Nb | 9.9×10⁸ | 999 | ○ |
| 1-4 | Nb | 1.2×10¹⁰ | 1010 | × |
| 1-5 | Nb | 2.3×10¹⁰ | 2050 | × |

When the largest area of the diamond continuous portion was less than 1 µm² as No. 1-1, diamond having deficient crystallinity was formed, and foreign matters attached to the surface, so that the electrolysis test could not proceed. When the largest area of the diamond continuous portion ranged from 1 µm² to 1,000 µm², as Nos. 1-2 and 1-3, both had filtration function and no delamination occurred between the porous substrate and the electroconductive diamond layer, in the case of using the diamond-covered substrate as electrode. However, when the largest area of the diamond continuous portion exceeded 1,000 µm² as Nos. 1-3 and 1-4, delamination occurred between the porous substrate and the electroconductive diamond layer in the case of using the diamond-covered substrate as electrode.

### (Example 2)

An electroconductive diamond film was formed on the porous substrates in which the open pore diameter varied as illustrated in Table 2. Using the produced diamond-covered substrates, a solution was circulated through the substrate by a pump that fed the solution from one side of the substrate towards the opposite side. As the solution, a mixture of a sludge-like precipitate including diamond powder and a mixed organic solution of trichloroethylene and acetone, was mixed into a 0.1 M aqueous solution of sulfuric acid, then it was used. An electrochemical oxidation treatment was carried out simultaneously while this solution was filtered. Filtration of the solution proceeded for 4 hours through recirculation of the solution.

**Table 2**

| No. | Substrate material | Open pore diameter (µm) | Test result |
|---|---|---|---|
| 2-1 | Nb | 0.09 | No solution passage |
| 2-2 | Nb | 0.11 | Filtration possible |
| 2-3 | Nb | 999 | Filtration possible |
| 2-4 | Nb | 1001 | Substrate breakage |

No. 2-1, which had a largest open pore diameter smaller than 0.1 µm, the porous substrate clogged with diamond during diamond film formation, so that the solution did not flow through. Nos. 2-2 and 2-3, which had a largest open pore diameter ranging from 0.1 µm to 1,000 µm, the solution could pass through continuously. When the largest open pore diameter exceeded 1,000 µm, as No. 2-4, the substrate broke immediately upon commencement of the test, and hence the test could not proceed.

### (Example 3)

An electroconductive diamond film was formed on a porous substrate by use of the substrate materials varied as shown in Table 3. An electrochemical oxidation treatment was carried out in the same way as in Example 1. × denotes substrates that suffered corrosion during the treatment, while ○ denotes substrates where no corrosion occurred. The electrochemical oxidation treatment was prolonged a further 100 hours with a current density of 1.5 A/cm² (electrolysis treatment 2). × denotes the substrates suffering delamination between the substrate and the diamond film, while ○ denotes the substrates where no such delamination occurred.

**Table 3**

| No. | Substrate material | Substrate corrosion | Electrolysis treatment 2 Film delamination |
|---|---|---|---|
| 3-1 | Al | ○ | × |
| 3-2 | Ta | ○ | × |
| 3-3 | Nb | ○ | ○ |
| 3-4 | Hf | ○ | × |
| 3-5 | Zr | ○ | × |
| 3-6 | Zn | ○ | × |
| 3-7 | Mo | × | - |
| 3-8 | Cu | × | - |

As for the substrate materials in Nos. 3-1 to 3-6, the electrochemical oxidation treatment could proceed stably. Other than them, Nos. 3-7 and 3-8 suffered corrosion at portions where the substrate was not covered by the electroconductive diamond layer then in direct contact with the solution, the substrate broke, and the treatment could not proceed.

### (Comparative example 1)

An electroconductive diamond film was formed under the same condition as in Example 1 using hot filament CVD, but herein without including boron as an impurity. During film formation, no diborane gas was fed, and carbon was used as an impurity which was doped in the electroconductive diamond layer to make the layer electroconductive. However, carbon corroded during the electrolysis treatment, which impaired adhesive strength between the electroconductive diamond layer and the substrate and gave rise to delamination, thereby the electrolysis treatment could not be continued.

### (Comparative example 2)

An electroconductive diamond film was formed under the same condition as in Example 1 using hot filament CVD, but herein the content of the boron impurity was changed. During film formation, the fed amount of the gas including boron was controlled so as to manufacture electroconductive diamond layers having a boron content of 0.9 ppm, 1,000 ppm and 60,000 ppm. The diamond electrode of the content 0.9 ppm exhibited a high electric resistance then the power efficiency during electrolysis treatment worsened comparing to the diamond electrode of the content 1,000 ppm. The electrode containing 60,000 ppm of boron, the diamond quality deteriorated and impurities adhered to the electrode surface during electrolysis treatment, thereby the power efficiency lowered.

### (Example 4)

An electroconductive diamond film was formed using substrates with the materials given in Table 4. The substrate was 3 mm-thick 50 mm × 50 mm flat plates. As a pretreatment, a scratching treatment with diamond powder or an ultrasonic treatment in a solution containing dispersed diamond powder was performed. The size of the diamond powder varied from 0.001 µm to 10 µm.

Synthesis by hot filament CVD was carried out under the conditions of a gas pressure of 30 Torr, a hydrogen flow of 2,500 sccm, and a methane flow range of 5 to 150 sccm. The boron source was diborane gas. The diborane flow was supplied at a concentration range of 0.2 to 1.0% with respect to methane. The temperature of the substrate was 700 to 1,000°C. In the case of microwave CVD, the microwave frequency was 2.4 GHz, and the microwave output was 5 kW. In all cases the boron contents were within the range of from 10 ppm to 10,000 ppm.

As displayed in Table 4, nucleation density was changed by modifying the methane flow, or the diamond seeding method in the pretreatment. After 30 min of film formation, a 1 mm square area was arbitrarily selected and the nucleation density of the section was measured. Further film formation was resumed thereafter, and then the surface area of the diamond cover was measured on the same location. An electrochemical oxidation treatment was carried out using the diamond-covered substrates as electrodes. Herein, ○ indicates no delamination, while × indicates the case in which the electroconductive oxidation treatment could not continue on account of delamination and/or substrate breakage. In the electroconductive oxidation treatment, two diamond electrodes were used as anode and cathode in a container filled with a 1 mol/L aqueous solution of sulfuric acid. The electrodes were fixed apart with a distance between them of 10 mm then electric current was supplied. Current flowed at 1.0 A/cm² for 100 hours (electrolysis treatment 3).

**Table 4**

| No. | Substrate material | Nucleation density (nuclei/cm²) | Area of diamond continuous portion (µ m²) | Delamination |
|---|---|---|---|---|
| 4-1 | Nb | 4.7×10⁸ | 10 | ○ |
| 4-2 | Nb | 9.9×10⁸ | 999 | ○ |
| 4-3 | Nb | 1.1×10¹⁰ | 1005 | × |
| 4-4 | Nb | 4.8×10¹⁰ | 3120 | × |

In Nos. 4-1 and 4-2, whose largest area of the diamond continuous portion were less than 1,000 µm², no delamination occurred between the substrate and the electroconductive diamond layer when the diamond-covered substrate was used as an electrode. In the substrate whose largest area of the diamond continuous portion exceeded 1,000 µm² as Nos. 4-3 and 4-4, however, delamination occurred between the substrate and the electroconductive diamond layer when the diamond-covered substrate was used as an electrode.

### (Example 5)

An electroconductive diamond film was formed on the porous substrates in which the substrate material was changed as shown in Table 5. The diamond film was formed under conditions identical to those of No. 4-1. The substrate was shaped as a 50 mm-diameter, 1 mm-thick disc. An electrochemical oxidation treatment was carried out in the same way as in Example 4. In the table, × denotes substrates that suffered corrosion during the treatment, while ○ denotes substrates where no corrosion occurred. The electrochemical oxidation treatment was prolonged a further 100 hours with a current density of 1.5 A/cm² (electrolysis treatment 4). In this case × denotes delamination between the substrate and the diamond film, while ○ denotes that no delamination occurred.

**Table 5**

| No. | Substrate material | Substrate corrosion | Electrolysis treatment 4 Film delamination |
|---|---|---|---|
| 5-1 | Al | ○ | × |
| 5-2 | Ta | ○ | × |
| 5-3 | Nb | ○ | ○ |
| 5-4 | Hf | ○ | × |
| 5-5 | Zr | ○ | × |
| 5-6 | Zn | ○ | × |
| 5-7 | Mo | × | - |
| 5-8 | Cu | × | - |

In the substrate materials of Nos. 5-1 to 5-6, the electrochemical oxidation treatment could proceed stably. In No. 5-7, portions where the substrate was in direct contact with the solution suffered corrosion, the substrate broke after 12 hours, and the treatment could not proceed. In No. 5-8, similarly, the substrate broke after 17 hours. Further prolongation of the electrochemical oxidation treatment resulted in delamination in No. 5-1 after 68 hours, in No. 5-2 after 57 hours, in No. 5-4 after 72 hours, in No. 5-5 after 65 hours, and in No. 5-6 after 81 hours, but no delamination of the electroconductive diamond layer occurred in No. 5-3 of the Nb substrate.

### (Comparative example 3)

An electroconductive diamond film was formed by hot filament CVD under the conditions substantially same as those of Example 4. During the film formation, no boron was fed, and carbon was used as an impurity which was doped in the electroconductive diamond layer to make the layer electroconductive. However, carbon corroded during the electrolysis treatment, which impaired adhesive strength between the electroconductive diamond layer and the substrate, and gave rise to delamination, thereby the electrolysis treatment could not be continued.

### (Comparative example 4)

An electroconductive diamond film was formed by hot filament CVD under conditions substantially same as those of Example 4. During the film formation, the fed amount of the gas including boron was controlled herein so as to manufacture electroconductive diamond layers having a boron content of 0.9 ppm, 1.1 ppm, 1,000 ppm, 99,000 ppm and 110,000 ppm. The electrode of the content 0.9 ppm exhibited a high electric resistance of film then exhibited a worse power efficiency during electrolysis treatment comparing to the diamond electrodes of the content 1.1 ppm, 1,000 ppm or 99,000 ppm. In the electrode of the content 110,000 ppm, the diamond quality deteriorated and impurities adhered to the electrode surface during electrolysis treatment, thereby power efficiency worsened.

## Claims

1. A diamond-covered substrate comprising a substrate and a diamond layer covering the substrate, wherein a largest area of a continuous portion of the diamond comprising the diamond layer ranges between not less than 1 µm² and not more than 1,000 µm².

2. A diamond-covered substrate according to claim 1, wherein said diamond layer is electroconductive.

3. A diamond-covered substrate according to claim 1 or 2, wherein said substrate is porous and has open pores.

4. A diamond-covered substrate according to claim 3, wherein the open pore diameter of said porous substrate is 0.1 µm to 1, 000 µm.

5. A diamond-covered substrate according to any one of claims 1 to 4, wherein a material of said porous substrate is Al, Ta, Nb, Hf, Zr or Zn.

6. A diamond-covered substrate according to any one of claims 1 to 5, wherein said diamond layer includes, as an impurity, at least one among boron, phosphorus and nitrogen.

7. A diamond-covered substrate according to claim 6, wherein said electroconductive diamond layer includes 1 ppm to 100,000 ppm of boron.

8. A diamond-covered substrate according to claim 7, wherein said electroconductive diamond layer includes 1 ppm to 50,000 ppm of boron.

9. A filter, used the diamond-covered substrate according to any one of claims 1 to 8.

10. An electrode using a diamond-covered substrate according to any one of claims 1 to 8 and/or a filter according to claim 9 as a cathode and/or an anode.
